# EUROPEAN PATENT SPECIFICATION

(11) **EP 0 398 481 B1**
(45) Date of publication and mention of the grant of the patent: **16.10.1996**
(21) Application number: 90303321.5
(22) Date of filing: 28.03.1990
(51) Int. Cl.: G06F 17/00, G01R 31/00, G01M 15/00

(54) **Method and apparatus for diagnosing an electronic automotive control system by means of pattern recognition**
Verfahren und Einrichtung zur Diagnose des elektronischen Steuersystems eines Kraftfahrzeuges mit Hilfe der Mustererkennung
Procedure et appareil pour diagnostiquer un système de réglage électronique d'un véhicule par intermédiaire de reconnaissance de caractères

(30) Priority: 18.05.1989 US 353726
(43) Date of publication of application: 22.11.1990
(73) Proprietor: FORD MOTOR COMPANY LIMITED, Brentwood, Essex CM13 3BW (GB); FORD FRANCE S. A., 92506 Rueil-Malmaison Cédex (FR); FORD-WERKE AKTIENGESELLSCHAFT, 50725 Köln (DE)
(72) Inventor: Marko, Kenneth Andrew, Ann Arbor, Michigan 48104 (US); James, John Victor, Michigan 48088 (US)
(74) Representative: Messulam, Alec Moses

(56) References cited:
- EP-A- 0 304 848
- WO-A-87/06371
- US-A- 4 424 709
- US-A- 4 796 206
- SAE TECHNICAL PAPER SERIES no. 870386, 1987, pages 385- 406, Warrendale, PA, US; J. JAMES et al.: "Microprocessor based data acquisition for analysis of engine perfomance"

## Description

The present invention relates in general to the identification of the operating condition of an internal combustion engine including fault conditions in the engine, and more specifically to the use of a pattern recognition system examining engine operating parameters to identify specific fault conditions in the engine.

Automotive control systems for internal combustion engines can include an electronic engine control for improved reliability, advanced functionality, and low cost. A typical electronic system includes a master engine controller and a plurality of sensors and actuators incorporated into the powertrain of a vehicle. The master engine controller processes data from the sensors using look-up tables and complex algorithms in. order to determine appropriate commands for the actuators. For example, engine position, engine speed, throttle position, and exhaust gas oxygen content can be monitored in order to determine a proper spark timing and dwell for engine operation. The particular strategy employed is designed to achieve compliance with federal emission regulations while optimising fuel economy and powertrain performance.

In addition to engine controls, several other automotive systems currently employ or are candidates for electronic controls. Such systems include anti-lock brakes, drive by wire systems, and transmission controls.

Operation of these electronic control systems must be highly reliable for safety reasons. When a fault develops, it must be possible to trace the cause of the fault to the plant (i.e., powertrain), the controller, or its sensors or actuators.

Due to the inherent complexity of electronic control systems, the task of diagnosing a fault becomes very difficult. Therefore, a great deal of effort has been expended in searching for diagnosis methods which require a minimum of skill or knowledge of the service technician.

Prior art attempts to provide electronic engine control fault diagnosis have involved computerisation in order to minimise the skill required to perform the diagnosis. For instance, a data acquisition system can be used to provide engine operating information to a computer which compares the information to pre-specified normal data. The measured values are compared with preset reference values in order to find discrepancies which indicate possible faults. Some systems also apply specific algorithms to measured values in order to determine specific engine characteristics. For example, the computer may determine an integrated average over time or may extract particular features of a waveform for analysis.

Several prior art engine diagnosis systems have employed the use of an expert system which is a rule based system for analysing input engine parameters according to rules describing the controlled system developed by an expert. An expert system requires an intense learning process by the expert to understand the system and to codify his knowledge into a set of rules. Thus, expert system development takes a large amount of time and resources. An expert system is not responsive to frequent design changes such as occur in automotive development. A change in engine design changes the rules, which requires the expert to determine the new rules and to redesign the system.

U.S. patent 4,252,013, issued to Hyanova et al, discloses a diagnostic system for an internal combustion engine in which pick-up devices sense engine parameters. Dynamic input signals are preprocessed in order to provide quasi-static indices of engine conditions. The preprocessed signals and other measured signals are applied to predetermined algorithms to give diagnostic indices of the internal combustion engine.

U.S. patent 4,375,672, issued to Kato et al, discloses a computerised engine analyser for making automatic diagnosis. Sensors connected to an internal combustion engine detect characteristics of the engine. The signals from the sensors are preprocessed and are then compared in a computer with a preset program corresponding to the engine. The results of various diagnoses of the engine are indicated as the diagnosis proceeds under control of an operator.

U.S. patent 4,418,388, issued to Allgor et al, discloses an engine analyser which measures engine operating parameters including electrical system waveforms which are then stored in the memory. The stored waveforms are compared to analytical matrices dictated by engine type. Based on the preprogrammed relationship of matrix locations and the input waveforms, information is processed to identify defective systems.

U.S. patent 4,424,709, issued to Meier Jr. et al, discloses an engine analyser for identifying engine defects based on signals from various sensors. The detected signals are compared with signals from normal engines in the frequency domain. By recognising specific differences, or looking for abnormal frequency components, engine defects are identified.

An expert system for car fault diagnosis is described in Armano et al, Empirical And Functional Knowledge In An Expert System For Fault Diagnosis, IEEE International Workshop on Artificial Intelligence for Industrial Applications, pages 109-114 (1988). The expert system architecture disclosed in this paper uses artificial intelligence techniques to incorporate both empirical knowledge and functional knowledge to reach a fault diagnosis.

The use of failure detection filters to diagnose automotive control systems is disclosed in Liubakka et al, Failure Detection Algorithms Applied To Control System Design For Improved Diagnostics And Reliability, SAE Technical Paper Series, Paper No. 880726 (1988). The failure detection and isolation method disclosed employs a system model for predicting system operation. Known relationships between system inputs and outputs allow the diagnostic system to anticipate a system output given detected system inputs. Any difference between the predicted system outputs and those detected by the sensors indicates a system fault.

Each of the prior art diagnostic systems requires predetermined engine analytical information in order to design a system to detect faults. As electronic systems increase in complexity, the determination of such analytical information becomes more difficult, time-consuming, and expensive. These are some of the problems this invention overcomes.

From patent application WO-A-8 706 371 an expert system using pattern recognition techniques is known which comprises processing means for receiving input data and operate on it to produce data indicative of a parameter or parameters which are considered to define or represent the condition of equipment or a system to be diagnosed and which provides a pattern recognition means which can be trained or instructed to recognise different combinations of input data as indicative of particular conditions of the equipment. The system is trained by coupling it initially to known good equipment into which definable faults are introduced. The pattern recognition means has a series of sections with adjustable weight coefficients which are adjusted in accordance with a given algorithm as successive data combinations associated with the various faults fed to the system. Once trained the system can diagnose unknown equipment and provide outputs indicative of faults.

It is a principal object of the present invention to diagnose operation of an electrical control system without requiring detailed analytical modelling of the system.

It is another object of this invention to provide a diagnostic system for detecting faults in complicated electronic control systems which is inexpensive to develop and provides accurate results.

It is a further object of the invention to provide a method for identifying selected conditions in a combustion engine using pattern recognition and for training a pattern recognition system to recognise the selected conditions.

It is still another object of the invention to provide an apparatus for identifying possible fault conditions in an internal combustion engine by employing a pattern recognizer which can be easily adapted to different engines.

These and other objects are achieved using a method for identifying selected conditions in an electronically controlled automotive system wherein a trainable pattern recognition system (such as a neural network) is employed according to the teachings of the invention. Specifically, a plurality of system operating trials are conducted using a test system, each trial including at least one respective one of a plurality of known selected conditions, such as fault conditions. System operating data is collected during the operating trials corresponding to a plurality of system parameters, the parameters including signals passing to and from an electronic control and calculated quantities derived therefrom. In the embodiment where the controlled system is a combustion engine, the parameters include measurements and calculations for each individual firing event during operation of the engine. System parameters and corresponding known system fault identities are input as training vectors to the pattern recognition system. During training, the pattern recognition system learns to correlate patterns in the system parameters with respective system faults. Subsequently, a system operating trial is conducted using a system to be diagnosed. The system diagnostic data corresponding to the system parameters is collected and the parameters based on the diagnostic data are input as input vectors to the pattern recognition system to identify those selected conditions which are present in the operation of the system to be diagnosed.

The invention further includes apparatus, for identifying possible fault conditions in an automotive system, that comprises monitor means, processing means, memory means, and pattern recognition means. The monitor means is adapted to be coupled to the system for collecting a plurality of time referenced values corresponding to selected system parameters during operation of the system, the parameters including signals passing to and from the system. The processing means is coupled to the monitor means for processing the values to derive system parameters and organising the system parameters into vectors. The memory means is coupled to the processing means for storing the vectors. The pattern recognition means is coupled to the memory means for classifying the stored vectors according to the possible fault conditions. The time referenced values may include digital values and analog values, the digital values being monitored upon occurrence of a transition therein, and the analog value being monitored at predetermined intervals.

The invention will now be described further, by way of example, with reference to the accompanying drawings, in which :
Figure 1 is a functional block diagram showing a pattern recognition system during training to recognise selected conditions in an engine;
Figure 2 is a functional block diagram showing detection of the selected conditions in an engine to be diagnosed by a trained pattern recognition system;
Figure 3 is a block diagram showing a data acquisition system connected to an engine and its electronic control;
Figure 4 is a block diagram showing the data acquisition means as part of a computerised fault detection system of the invention in greater detail;
Figure 5 is a functional block diagram showing processing of engine operating data to generate engine parameters for applying to the pattern recognition system;
Figure 6 is a matrix of parameter vectors for application to a pattern recognition system;
Figure 7 is a block diagram showing the inputs and outputs for the pattern recognizer of the invention;
Figure 8 illustrates the matrix of combinations of parameter vectors and condition classification codes during training of the pattern recognition system;

The present invention enables diagnosis of faults in a variety of electronically controlled electromechanical systems. Fault diagnosis is performed as a passive observer of system operation using only the information that is available within the system while it is operating. Furthermore, by proper selection of system parameters to be observed, high accuracy in failure detection is achieved by means of a pattern recognition system. The preferred embodiment and best mode of the invention specifically relates to fault diagnosis in an electronically controlled internal combustion engine, as is described below.

The electronically controlled internal combustion engine is a complex system in which high speed analog and digital signals are sent to and from the electronic control during engine operation. Some characteristics of a high speed data acquisition system for collecting the analog and digital data from sensors and actuators in an electronically controlled engine are in James et al, Microprocessor Based Data Acquisition For Analysis Of Engine Performance, SAE Technical Paper Series, Paper No. 870386 (1987).

The amount of data collected by such a data acquisition system, even during a single engine cycle, is very large. Furthermore, the variations between data from normal engine operation and faulty engine operation can be subtle. Therefore, it can be very difficult to train a technician to associate each pattern with a specific engine fault. Likewise, developing an explicit algorithmic computer program or creating an expert system to perform the association can only be done with great effort and expense.

In accordance with the present invention, a pattern recognition system such as a neural network simulation program used in conjunction with the high speed data acquisition system can produce a diagnostic system which can be trained to correlate signatures of improper engine performance with causes of faults. During training of the pattern recognition system, an engine is operated in a service bay with known faults, i.e. bugs, with each operating trial being tagged according to the fault introduced. Data from a normal (i.e., unbugged) engine is also included. Subsequently, an engine operating with a previously unidentified fault can be identified using the trained system.

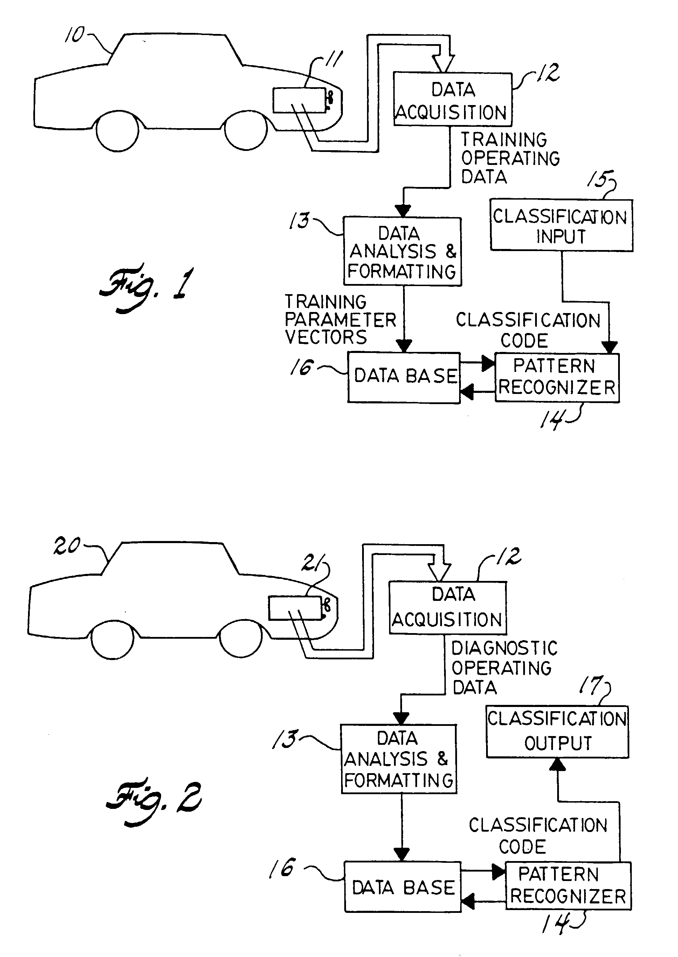

Referring now to Figure 1, an automobile 10 includes an electronically controlled engine 11. Operating data in the form of electrical signals associated with an electronic controller in engine 11 are collected by a data acquisition unit 12 which provides the operating data to a data analysis and formatting unit 13. At least one parameter vector is provided from unit 13 to a pattern recognizer 14 in conjunction with an engine condition classification from a classification unit 15. Pattern recognizer 14 is coupled to a data base 16 which is built up during training of the system.

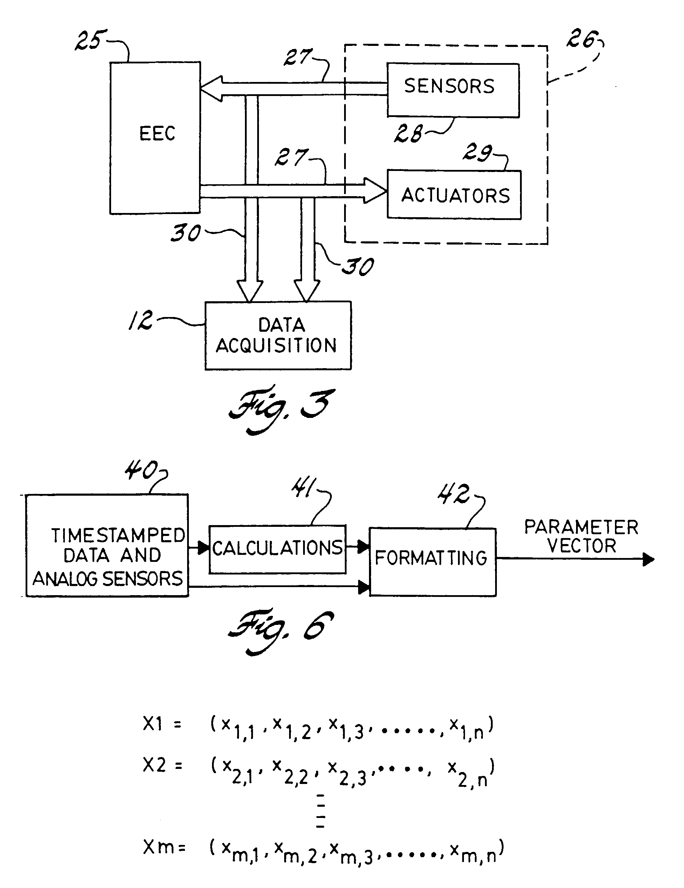

Figure 2 corresponds to operation of the diagnostic system after training for the purpose of identifying the condition of an engine. An automobile 20 includes an electronically controlled engine 21 to be diagnosed which is substantially identical to engine 11 which was employed during training. Diagnostic operating data is obtained by data acquisition unit 12 and provided to data analysis and formatting unit 13. A diagnostic parameter vector is provided to pattern recognizer 14 which classifies the vector according to the trained data base 16. A classification output is provided at 17 corresponding to the attempted classification of the operating condition of engine 21.

Functional blocks 13-17 of Figures 1 and 2 can preferably be implemented with a computer such as a PC or an on-board microcomputer, such as in the electronic engine control itself.

The training of the system, as shown in Figure 1, requires the compilation of a large data base from test engine 11 which is first monitored while operating properly and then with known "bugs" created by a technician. The technician creates various faults in the vehicle while the computer acquires, analyzes, and formats the results for inclusion in the data base, along with a coded classification of the particular cause of the fault, provided by the technician.

The operating data acquired from the engine can be used in calculations to determine exact engine operating parameters. The parameters and the fault classifications are formatted as multidimensional vectors. Preferably, each parameter vector contains at least 52 performance parameters for a single cycle of a six cylinder engine. Since statistical fluctuations can cause variations in exact parameter values, preferably at 16 vectors are stored for each test condition of engine 11. The utility and accuracy of the system is strongly influenced by the representation chosen both for fault identification codes generated as output during diagnosis and for engine operating parameters used in the parameter vector,s input to pattern recognizer 14. Using the particular engine parameters and the selected fault conditions described below, not only the engine cylinder at fault but also the nature of the fault, including indications of faulty components and indication of components that are functioning properly, can be obtained. The diagnostic system is very precise in identifying faults and accomplishes the identification of multiple simultaneous faults under many conditions.

Continuing with the operation of the system shown in Figures 1 and 2, after a large data base of fault information has been gathered and formatted by data analysis and formatting unit 13, pattern recognizer 14 and data base 16 undergo training. During training, the system recursively adjusts its internal structure until the system has learned the proper association between parameter vectors from an engine and fault classifications introduced through the classification input. The trained system parameters are saved in data base 16 and the trained system may then be presented with new data from engine 21. No classification input is presented to the system, since the system is expected to classify the new data according to previous classifications. The classification output from the system can be an indication of proper engine operation, an identification of one or more classified conditions which were introduced during training, or an indication of an inability to recognise any trained condition.

For powertrain diagnostics, the data acquired from the vehicle is based upon the signals communicated between the on-board electronic engine control (EEC) and the powertrain (engine). The set of signals captured for analysis is based upon a determination of the information that is necessary for accurate diagnosis and upon the ability of the data acquisition system to acquire and store the signals. The information used for data acquisition, training and diagnosis preferably includes the following signals and calculated parameters:

### Engine Crankshaft Position Marker

The engine crankshaft position is sensed by the Profile Ignition Pickup (PIP) sensor located on the distributor shaft. The PIP signal is a digital signal which changes level at 10 degrees before top-dead-centre (10axa BTDC) on each firing cylinder for every engine cycle (two complete revolutions of the crankshaft for a 4-stroke engine). PIP is the primary source of information about engine performance during each cycle, since we can derive the parameters of crankshaft velocity and acceleration from it by taking the appropriate derivatives. In another embodiment, this signal is derived from a sensor directly monitoring the crankshaft with a higher sampling rate. The greater accuracy of a high data rate sensor improves sensitivity of the system in detecting engine roughness caused by faulty components.

### Engine Speed (RPM)

Based on the PIP signal, engine speed in revolutions per minute is calculated as an engine parameter.

### Acceleration (ACCEL)

Based on the PIP signal or a high data rate position sensor, engine acceleration averaged over one engine cycle is calculated. Preferably, the average is determined as a median filtered value.

### Cylinder Acceleration (NACCEL)

Engine acceleration during an individual cylinder firing is calculated and the difference taken from the average acceleration during the engine cycle. This parameter gives information about misfiring cylinders.

### Spark Output (SPOUT)

This signal is an output from the EEC which controls the time of firing of the individual spark plugs. It is calculated by the EEC in a manner to maximise fuel economy within emissions constraints. Monitoring this signal provides an indication of proper operation of the spark strategy including the calculated parameter of actual spark advance for each cylinder firing.

### Tachometer (TACH)

This signal is obtained from the primary of the ignition coil. The shape of this signal and its timing provides information on dwell (the length of time the coil is being charged) and on arc duration (the length of time a spark is present in the spark plug gap). Analysis of these signals in conjunction with the SPOUT signal provides diagnostic information about the ignition system and its operation.

### Manifold Absolute Pressure (MAP)

This signal is an indication of the airflow into the engine and is based upon a sensor whose output typically is a frequency linearly related to the pressure in the intake manifold.

### Mass Air Flow (MAF)

On some newer vehicles, airflow into the engine is measured directly by this sensor, rather than inferred manifold pressure (MAP) and other parameters. The output of this sensor may be an analog voltage whose value is proportional to the mass of air flowing into the engine.

### Air Charge Temperature (ACT)

An analog voltage output from this sensor provides information on the temperature of the incoming air and is used by the EEC to estimate the air density in calculating the amount of air flowing into the engine.

### Throttle Position (TP)

This sensor monitors the position of the vane controlling air admission to the engine under the command of the driver through the linkage to the accelerator pedal. It is an analog voltage proportional to the degree of throttle opening.

### Pressure Feedback Exhaust Gas Recirculation (PFE)

This signal is derived from a pressure sensor on the exhaust side of the exhaust gas recirculation (EGR) valve which is controlled by the electronic vacuum regulator (EVR) signal from the EEC. Correlating this PFE signal with the EVR controlling signal from the EEC can be used to diagnose improper operation of the EGR system, as well as to detect the presence of other engine faults such as defective valves.

### Injector Control Pulses (INJ)

These signals are delivered to the fuel injectors and control the timing and the amount of fuel (pulse width) delivered to each cylinder. These signals provide timing and pulse width information to diagnose the operation of the fuel delivery system.

### Exhaust Gas Oxygen (HEGO)

This sensor has an output which is substantially binary in its response to the presence or absence of oxygen in the exhaust gas. Proper system operation regulates the engine so that the mixture is, on average, neither rich nor lean. When the mixture transits from rich to lean, the output of this sensor changes abruptly. The output of this sensor is used by the EEC to control the mixture ratio so that the sensor is constantly switching between its two states, indicating that the mixture is near stoichiometric.

### Idle Speed Control (ISC)

This signal from the EEC is a duty cycle modulated pulse which opens an air by-pass valve against a spring to regulate the idle speed of the vehicle. Correlating the ISC signal with the idle speed variations and MAP provides a means of diagnosing faults in the ISC system.

### Engine Coolant Temperature (ECT)

This is the output of a sensor in the cooling fluid in the engine which is an analog voltage proportional to the cooling system temperature. This signal is used in the EEC control system to activate a cold engine strategy and to control the cooling system to maintain proper engine temperature after warm-up.

### Knock Sensor

This is the output of a sensor used in some high performance engines to detect the presence of engine knock. The signal is used to regulate the spark timing to avoid continuous engine knock which could damage the engine if it continued for long periods of time.

### Vehicle Speed Sensor (VSS)

This sensor provides an output proportional to the driveshaft speed for regulating vehicle speed by speed-control system, often incorporated into the EEC.

### Vehicle Battery Voltage (VBAT)

This is an EEC signal proportional to the battery voltage in the car.

Turning now to Figure 3, the connection of data acquisition system 12 to an electronically controlled engine is shown for rapidly gathering the large amount of data required to assess vehicle performance. An engine 26 includes a plurality of sensors 28 and a plurality of actuators 29. An electronic engine control (EEC) 25 communicates with sensors 28 and actuators 29 over communication lines 27. Data acquisition system 12 monitors signals on lines 27 by means of a plurality of signal lines 30. Data acquisition system 12 acquires and stores signals being communicated to and from EEC 25 at a sufficiently high rate such that various parameters of engine performance at the actual level of firing events can be determined. One possible approach for acquiring engine data suitable for the present invention is discussed in the paper James et al, Microprocessor Based Data Acquisition For Analysis Of Engine Performance, SAE Technical Paper Series, Paper No. 870386 (1987), mentioned earlier.

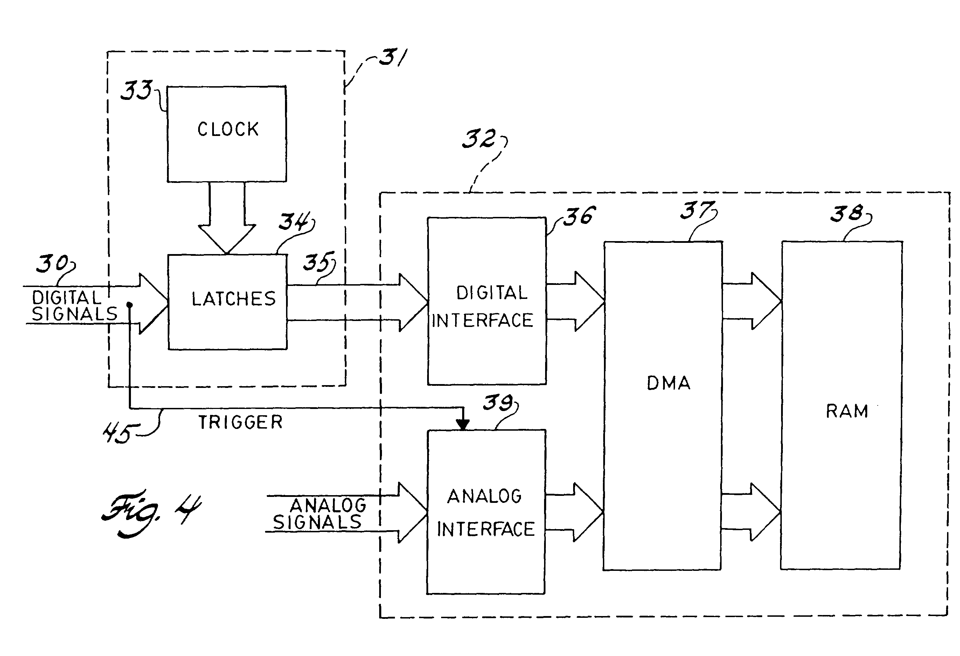

A preferred embodiment for implementing data acquisition system 12 is shown in Figure 4. Data is acquired and stored according to a timestamping procedure. As described in the above-referenced article, timestamping of digital signals only records changes which occur on any of the lines being monitored along with the time that the change occurs.

As shown in Figure 4, the signal acquisition lines 30 are separated according to digital signals and analog signals. The digital signals are coupled to a timestamping board 31 including clock 33 and latches 34. Latches 34 are coupled via output lines 35 to a digital interface 36 in a microcomputer 32. Analog signals from lines 30 are coupled to an analog interface 39 also in microcomputer 32. Digital interface 36 and analog interface 39 are each coupled to a direct memory access (DMA) unit 37 which controls direct memory transfer to a random access memory (RAM) 38. A selected digital line from digital signals 30 is connected to analog interface 39 over a line 45 for acting as a trigger of analog measurements as discussed below.

In operation, digital signals from lines 30 are monitored by latches 34 such that the previously timestamped values (or initial values taken when monitoring begins) are compared with the current values. Upon a change in any digital value, a new timestamped output consisting of the value of each digital line (or identification of the line or lines that changed) is output over lines 35 along with the clock value at the time the change occurred. The new timestamped digital values are processed by digital interface 36 and transferred via DMA 37 such that the values and time signature are stored in RAM 38 in substantially real-time. Preferably, the transfer of timestamped data occurs at a speed which allows a resolution in timestamped data of about two microseconds.

Analog signals from lines 30 are likewise stored in association with a timestamping signal. According to the present embodiment, analog signals are measured upon each occurrence of a particular substantially periodic digital signal from the digital lines 30. In particular, for electronically controlled engine applications, the trigger for taking analog measurements is preferably a transition of an engine position signal such as the PIP described earlier. In response to the trigger pulse on line 45, analog interface 39 samples a plurality of analog signals substantially simultaneously. They are then converted to digital signals by analog-to-digital converters within the interface. The digitised signals are provided via DMA 37 and are stored in RAM 38 in association with the digital timestamped signals occurring simultaneously. Thus, the analog signals can be correlated to the clock reading coinciding with the digital timestamped output including the trigger pulse. Once a sufficient amount of data is contained in RAM 38, microcomputer 32 is free to process the data in order to calculate various engine operating parameters or other values. Such processing may begin after completion of data acquisition or may be performed concurrently with data acquisition in order to diagnose engine conditions in real time.

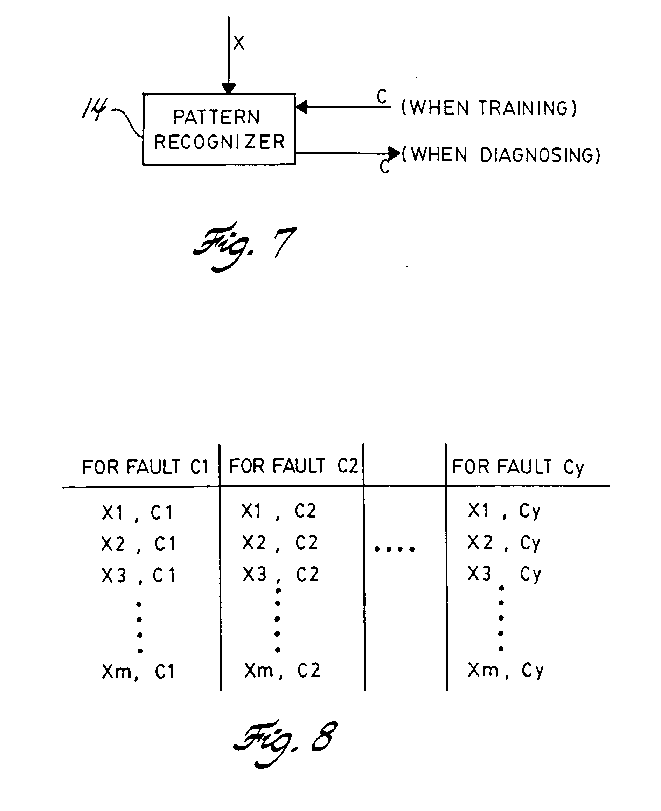

Subsequent processing of data can be performed according to the diagram in Figure 5. Time-referenced data 40 can be input to a number of calculations 41. The output of calculations 41 and some unchanged data (e.g., from analog sensors) are input to a formatting section 42 which operates to organise the engine operating data and parameters into a parameter vector appropriate for input to the pattern recognition system.

Figure 6 shows a plurality of training vectors for training of the pattern recognition system. A first parameter vector X1 consists of a plurality of individual parameter values x?1,1> to x?1,n>. Figure 6 shows m parameter vectors (X1 to Xm) where m is a sufficient number to adequately train the pattern recognition system to accurately recognise the preselected conditions. The individual parameter values x?1> to x?n> are preferably comprised of the parameters discussed above, including cylinder number, engine speed, acceleration, spark timing, spark duration, dwell, mass airflow, throttle position, feedback exhaust gas recirculation pressure, fuel injector pulse width, exhaust gas oxygen content, idle speed control duty factor, engine temperature, knock, vehicle speed, and battery voltage. Each parameter corresponds to an individual firing event, i.e., to a particular PIP signal. Although some of the digital signals obtained from timestamping are synchronous with the PIP signal, most are not. All digital transmissions are collected as they occur, but in post-processing, the relevant engine parameters are calculated from the digital signals associated with the PIP interval nearest in time. The parameters are determined once per engine firing, and information from several engine firings provides the plurality of training vectors X1 to Xm. Some parameters known to be slowly varying (e.g., various temperatures) can be averaged over the full engine cycle to yield a single value for inclusion into a vector in order to avoid unnecessarily large vectors.

Multiple sets of training vectors X1 to Xm are obtained corresponding to selected engine operating conditions. Each set corresponds to either normal operation or operation under a fault condition. As shown in Figure 7, pattern recognizer 14 receives a parameter vector X simultaneously with a condition code C during training. When m is equal to 16, then 16 parameter vectors X will be presented to pattern recognizer 14 along with a single condition code C. For the next operating condition being presented to pattern recognizer 14, a different set of 16 parameter vectors X are presented simultaneously with a new condition code C. Once training is complete, only a single parameter vector X need be presented to pattern recognizer 14 which then outputs one or more condition codes C corresponding to engine conditions reckoned within the parameter vector.

Figure 8 shows the combination of inputs to pattern recognizer 14 for training on a number of conditions C1 to Cy. For example, an electronically controlled engine is operated under a first fault condition C1. Preferably, the engine is operated at a steady speed. Data is obtained corresponding to a plurality of engine firings sufficient to construct m parameter vectors. Next, the engine is operated with a new induced fault C2 while timestamped data is obtained to construct a new set of parameter vectors X1 to Xm. The process is repeated until the last fault or normal operating condition Cy is obtained.

Once the full set of parameter vectors is completed, they are mated to their corresponding condition code as shown in Figure 8 and presented to pattern recognizer 14. For improved speed and accuracy of training, it is preferable to present the training vectors to pattern recognizer 14 in a randomized order, i.e., not all of the vectors corresponding to a respective fault condition are presented sequentially. The internal reorganisation of the pattern recognition data base converges to a proper configuration more efficiently when such a random order of vectors is used. Furthermore, several passes through the sets of vectors Preferably, the operating conditions for which training occurs on an electronically controlled engine includes both cylinder specific faults, cylinder independent faults, and a normal operating condition. The cylinder specific faults preferably include, at least, a shorted spark plug, an open spark plug, and a clogged fuel injector. Cylinder independent faults preferably include a shorted manifold absolute pressure sensor, an open manifold absolute pressure sensor, a shorted exhaust gas oxygen sensor, an open exhaust gas oxygen sensor, and idle speed control duty cycle faults.

Additional fault conditions can include intake and exhaust valve train faults such as valves open or closed, head gasket leaks, partial clogging of fuel injectors, fouled spark plugs, uneven air/fuel mixture among cylinders, and improper fuel injection phasing. Although parameter vectors are conveniently collected for each fault in isolation, it is possible for pattern recognizer 14 to identify simultaneous fault occurrences even though no training data was taken with simultaneous occurrence of the same faults. Furthermore, with proper training, the system recognise and identifies a specific cylinder where a cylinder specific fault has occurred.

The present invention has been implemented for a six-cylinder electronically controlled engine. A parameter vector including 52 individual parameters (both one-per-firing and once-per-cycle) was used. In this implementation, 26 different operating conditions (both cylinder specific and non-cylinder specific) were observed with the engine operating at about 1000 rpm. The training set consisted of 16 parameter vectors for each condition (e.g., failure) introduced. After training, as little as one parameter vector from an engine to be diagnosed is all that is required by the pattern recognizer for correct classification.

In a preferred embodiment, the pattern recognizer system included a backpropagation method for learning patterns and classifications. Such mathematical pattern recognition algorithms are well known in the art. In another preferred embodiment, the pattern recognizer comprised the Nestor NDS-1000 System available from Nestor Incorporated, New York, New York. After complete training, the Nestor system obtained 100% accuracy in identifying the operating condition of an engine being diagnosed.

In implementing the entire system using pattern recognition software, a microcomputer is employed for linking computer recognition software (e.g., a backpropagation program or the Nestor software) into a larger program which performs data acquisition and data formatting and preparation, such as cycle binning, normalisation, and scaling. Although the time for manually collecting parameters according to all the engine conditions to be recognised can take several hours, the training vectors are learned by the pattern recognition system in about 5-10 minutes. Thus, faults are then reintroduced at a later time and can be recognised by the system of the present invention without any modeling or other detailed knowledge of the operation of the engine system. Any modification to the engine requires that new data be taken and the system be retrained. However, the reformulation of detailed rules which would be required by an expert system are avoided.

The present invention has been implemented using primarily commonly available hardware and software. Thus, an effective and efficient technique has been provided for proper diagnosis of electronic systems. Furthermore, the system is readily transferable to systems on-board an electronic engine control for continuous diagnosis of engine operation in a vehicle.

Although the separate sensing of signals passing to and from an EEC has been shown in the preferred embodiment, many of the calculated values may be available from calculations being performed in the EEC itself (e.g., spark timing and RPM). Rather than duplicate such calculations, it is possible to obtain these parameters from the ECC over a data communication link or other data port if one is provided in the EEC. Another possible modification of the invention involves the use of a vector which contains information from multiple cycles. This allows additional fault conditions to be recognised such as idle hunting.

## Claims

1. A method for identifying selected conditions in a combustion engine comprising the steps of, conducting a plurality of engine operating trials using a test engine, each trial including at least one respective one of a plurality of known selected engine operating conditions, collecting engine operating data during said operating trials corresponding to a plurality of engine parameters, said parameters including individual firing events inputting said engine parameters and respective condition codes as training vectors to a pattern recognition system to correlate patterns in said engine parameters with respective selected engine operating conditions, the training vectors input to the pattern recognition system being in multiple sets corresponding respectively to the selected engine operating conditions, each vector in each set being associated with a condition code corresponding to the respective engine operating condition, conducting an engine operating trial using an engine to be diagnosed, collecting engine diagnostic data corresponding to said plurality of engine parameters, and inputting said engine parameters based on said diagnostic data as input vectors to said pattern recognition system to regenerate at least one condition code corresponding to one of said selected engine operating conditions present in said engine to be diagnosed.

2. A method according to claim 1, wherein said selected conditions include a proper running condition of said combustion engine and conditions corresponding to fault conditions causing improper operation of said combustion engine.

3. A method according to claim 1, further comprising the steps of, calculating at least one of said engine parameters in said training vectors from said engine operating data, and calculating at least one of said engine parameters in said input vectors from said diagnostic data.

4. A method according to claim 1, wherein said test engine and said engine to be diagnosed include an electronic engine control and wherein said engine parameters are derived from input signals to and output signals from said electronic engine control.

5. A method according to claim 4 wherein said input signals and said output signals include both analog and digital representations.

6. A method according to claim 1, wherein said parameters include engine conditions averaged over a predetermined time period.

7. A method according to claim 6, wherein said predetermined time period is one engine cycle.

8. A method according to claim 1, wherein said parameters include engine conditions determined once per cylinder firing.

9. A method according to claim 1, wherein said pattern recognition system is comprised of a microcomputer programmed to perform a neural network simulation or a backpropagation analysis.

10. A method according to claim 1, wherein said firing events include spark advance for each engine cylinder, a signal related to engine position, deviation of acceleration of a single cylinder from average acceleration over one engine cycle, deviation of acceleration of a single cylinder from median filtered acceleration over one engine cycle, exhaust gas oxygen content, exhaust gas recirculating pressure, each fuel injection pulse width or each fuel injection pulse timing.

11. A method according to claim 6, wherein said averaged conditions include idle speed control duty cycle, engine speed, engine acceleration, or throttle position.

12. A method according to claim 8, wherein said conditions determined once per engine cycle include air charge temperature or engine coolant temperature.

13. Apparatus for identifying selected conditions in a combustion engine comprising, monitor means (12) for collecting engine operating data from the engine during a plurality of engine operating trials, each trial including at least one respective one of a plurality of known selected engine operating conditions, the data collected by the monitoring means corresponding to a plurality of engine parameters, said parameters including individual firing event parameters, processing means (13) for analyzing and formatting the operating data for entry as training vectors into a database (16), means (15) to enter condition codes corresponding to respective engine operating conditions, the training vectors input to the database being in multiple sets corresponding respectively to the selected engine operating conditions and each vector in each set being associated with a condition code corresponding to the respective operating condition, and pattern recognition means (14) coupled to the database (16) for recognising input vectors based on diagnostic data presented thereto from an engine to be diagnosed and regenerating at least one condition code corresponding to at least one of the said selected operating conditions of the engine to be diagnosed.

14. An apparatus according to claim 13, wherein the data collected by the monitoring means include digital values and analog values, said digital values being monitored upon occurrence of a transition therein, and said analog values being monitored at predetermined intervals.

## Patentansprüche

1. Ein Verfahren zur Identifizierung ausgewählter Zustände eines Verbrennungsmotors, umfassend die Schritte des Ausführens einer Vielzahl von Motorbetriebstests auf einen Testmotor, wobei jeder Test mindestens jeweils einen aus der Vielzahl der ausgewählten bekannten Motorbetriebszustände umfaßt, des Sammelns der auf eine Vielzahl von Motorparametern bezogenen Motorbetriebsdaten während dieser Betriebstests, wobei diese Parameter einzelne Zündvorgänge umfassen, der Eingabe dieser Motorparameter und der jeweiligen Zustandscodes als Trainingsvektoren in ein Mustererkennungssystem, um die Muster in diesen Motorparametern mit den jeweils ausgewählten Motorbetriebszuständen zu korrelieren, wobei die Eingabe der Trainingsvektoren in das Mustererkennungssystem in mehreren Sätzen durchgeführt wird, die jeweils den ausgewählten Motorbetriebszuständen entsprechen, wobei jeder Vektor aus jedem Satz einem Zustandscode zugeordnet wird, der dem jeweiligen Motorbetriebszustand entspricht, des Durchführens eines Motorbetriebstests mit einem zu untersuchenden Motor, des Sammelns von Motordiagnosedaten, die dieser Vielzahl von Motorparametern entsprechen, und der Eingabe dieser Motorparameter auf der Grundlage dieser Diagnosedaten als Eingabevektoren in dieses Mustererkennungssystem, um mindestens einen Zustandscode wieder zu erzeugen, der einem dieser ausgewählten Betriebszustände entspricht, die in diesem zu untersuchenden Motor vorliegen.

2. Ein Verfahren nach Anspruch 1, worin diese ausgewählten Zustände einen Zustand der ordnungsgemäßen Funktion dieses Verbrennungsmotors umfassen sowie Zustände, die Fehlerzuständen entsprechen, welche eine nicht ordnungsgemäße Funktion dieses Verbrennungsmotors verursachen.

3. Ein Verfahren nach Anspruch 1, das ferner die Schritte der Berechnung von mindestens einem dieser Motorparameter in diesen Trainingsvektoren aus diesen Motorbetriebsdaten und der Berechnung von mindestens einem dieser Motorparameter in diesen Eingabevektoren aus diesen Diagnosedaten umfaßt.

4. Ein Verfahren nach Anspruch 1, worin dieser Testmotor und dieser zu untersuchende Motor eine elektronische Motorsteuerung umfassen, und worin diese Motorparameter aus den Eingabesignalen in dieser elektronischen Steuerung und den Ausgabesignalen von dieser elektronischen Steuerung abgeleitet werden.

5. Ein Verfahren nach Anspruch 4, worin diese Eingabesignale und diese Ausgabesignale sowohl Analog- als auch Digitaldarstellungen umfassen.

6. Ein Verfahren nach Anspruch 1, worin diese Parameter über einen vorgegebenen Zeitraum gemittelte Motorzustände umfassen.

7. Ein Verfahren nach Anspruch 6, worin dieser vorgegebene Zeitraum aus einem Arbeitsspiel des Motors besteht.

8. Ein Verfahren nach Anspruch 1, worin diese Parameter Motorzustände umfassen, die einmal pro Zylinderzündung bestimmt werden.

9. Ein Verfahren nach Anspruch 1, worin dieses Mustererkennungssystem einen Mikrocomputer umfaßt, der so programmiert ist, daß er die Simulation eines neuronalen Netzwerkes oder eine Backpropagation-Analyse durchführt.

10. Ein Verfahren nach Anspruch 1, worin diese Zündvorgänge die Vorzündung für jeden Motorzylinder umfassen, ein Signal, das sich auf die Motorposition bezieht, die Abweichung der Beschleunigung eines einzelnen Zylinders vom Mittelwert der Beschleunigung über ein Arbeitsspiel, den Sauerstoffgehalt der Abgase, den Rückführungsdruck der Abgase, die Breite jedes Pulses für die Kraftstoffeinspritzung oder die Synchronisation jedes Pulses für die Kraftstoffeinspritzung.

11. Ein Verfahren nach Anspruch 6, worin diese gemittelten Zustände das Arbeitsspiel der Leerlaufdrehzahlsteuerung, die Motordrehzahl, Motorbeschleunigung oder die Drosselstellung umfassen.

12. Ein Verfahren nach Anspruch 8, worin diese einmal pro Arbeitsspiel bestimmten Zustände die Temperatur der Luftladung oder die Temperatur des Motorkühlmittels umfassen.

13. Ein Gerät zur Identifizierung ausgewählter Motorzustände eines Verbrennungsmotors, umfassend eine Überwachungsvorrichtung (12) zum Sammeln der Motorbetriebsdaten vom Motor während einer Vielzahl von Motorbetriebstests, wobei jeder Test mindestens jeweils einen aus der Vielzahl der ausgewählten bekannten Motorzustände umfaßt, wobei die durch die Überwachungsvorrichtung gesammelten Daten einer Vielzahl von Motorparametern entsprechen, wobei diese Parameter die Parameter einzelner Zündvorgänge umfassen, eine Verarbeitungsvorrichtung (13) zum Analysieren und Formatieren der Betriebsdaten, um sie als Trainingsvektoren in eine Datenbank (16) einzutragen, eine Vorrichtung (15) zur Eingabe von Zustandscodes, die den jeweiligen Motorbetriebsbedingungen entsprechen, wobei die Eingabe der Trainingsvektoren in die Datenbank in mehreren Sätzen durchgeführt wird, die jeweils den ausgewählten Motorbetriebsbedingungen entsprechen und wobei jeder Vektor in jedem Satz einem Zustandscode zugeordnet ist, der dem jeweiligen Betriebszustand entspricht, und eine Mustererkennungsvorrichtung (14), die mit der Datenbank (16) gekoppelt ist, um die Eingabevektoren auf der Grundlage von diagnostischen Daten zu erkennen, die ihr von einem zu untersuchenden Motor angeboten werden und die zumindest einen Zustandscode wieder erzeugen, der zumindest einem dieser ausgewählten Betriebszustände des zu untersuchenden Motors entspricht.

14. Ein Gerät nach Anspruch 13, worin die von der Überwachungsvorrichtung gesammelten Daten Digitalwerte und Analogwerte umfassen, wobei diese Digitalwerte auf das Auftreten einer Veränderung darin untersucht werden, und diese Analogwerte in vorgegebenen Zeitabständen überwacht werden.

## Revendications

1. Méthode pour identifier des conditions sélectionnées dans un moteur à combustion comprenant les étapes consistant à :
- effectuer plusieurs tests de fonctionnement du moteur en utilisant un moteur d'essai, chaque test incluant au moins l'une respective des conditions de fonctionnement du moteur sélectionnées connues,
- collecter les données de fonctionnement du moteur durant lesdits tests de fonctionnement correspondant à plusieurs paramètres du moteur, lesdits paramètres incluant des événements d'allumage individuels, entrer lesdits paramètres du moteur et les codes de condition respectifs en tant que vecteurs de formation dans un système de reconnaissance des formes de manière à corréler des formes dans lesdits paramètres du moteur avec des conditions respectives de fonctionnement du moteur sélectionnées, les entrées de vecteurs de formation dans le système de reconnaissance des formes étant divisées en multiples ensembles correspondant respectivement aux conditions de fonctionnement du moteur sélectionnées, chaque vecteur dans chaque ensemble étant associé à un code de condition correspondant à la condition de fonctionnement du moteur respective,
- effectuer un test de fonctionnement du moteur en utilisant un moteur devant être diagnostiqué,
- collecter les données de diagnostic du moteur correspondant auxdits plusieurs paramètres du moteur, et
- entrer lesdits paramètres du moteur basés sur lesdites données de diagnostic en tant que vecteurs d'entrée dans ledit système de reconnaissance des formes afin de générer au moins un code de condition correspondant à l'une des conditions de fonctionnement du moteur sélectionnées présentes dans ledit moteur devant être diagnostiqué.

2. Méthode selon la revendication 1, dans laquelle lesdites conditions sélectionnées incluent une condition de fonctionnement correcte dudit moteur à combustion et des conditions correspondant à des conditions d'anomalie causant un mauvais fonctionnement dudit moteur à combustion.

3. Méthode selon la revendication 1, comprenant également les étapes consistant à calculer au moins l'un desdits paramètres du moteur dans lesdits vecteurs de formation provenant desdites données de fonctionnement du moteur et à calculer au moins l'un desdits paramètres du moteur dans lesdits vecteurs d'entrée provenant desdites données de diagnostic.

4. Méthode selon la revendication 1, dans laquelle ledit moteur test et ledit moteur devant être diagnostiqué incluent un dispositif de commande du moteur électronique et dans laquelle lesdits paramètres du moteur sont dérivés de signaux d'entrée et de signaux de sortie provenant dudit dispositif de commande du moteur électronique.

5. Méthode selon la revendication 4, dans laquelle lesdits signaux d'entrée et lesdits signaux de sortie incluent des représentations à la fois numériques et analogiques.

6. Méthode selon la revendication 1, dans laquelle lesdits paramètres incluent des conditions de moteur mesurées en moyenne pendant une période de temps prédéterminée.

7. Méthode selon la revendication 6, dans laquelle ladite période de temps prédéterminée est un cycle de moteur.

8. Méthode selon la revendication 1, dans laquelle lesdits paramètres incluent des conditions de moteur déterminées une fois par allumage du cylindre.

9. Méthode selon la revendication 1, dans laquelle ledit système de reconnaissance des formes consiste en un micro-ordinateur programmé pour effectuer une simulation de réseau neuronal ou une analyse de rétropropagation.

10. Méthode selon la revendication 1, dans laquelle lesdits événements d'allumage incluent une avance d'allumage pour chaque cylindre du moteur, un signal lié à la position du moteur, la déviation d'accélération d'un seul cylindre par rapport à une accélération moyenne pendant un cycle de moteur, la déviation d'accélération d'un seul cylindre par rapport à une accélération filtrée moyenne pendant un cycle de moteur, la teneur en oxygène des gaz d'échappement, la pression de recirculation des gaz d'échappement, chaque largeur d'impulsion d'injection de carburant ou chaque synchronisation d'impulsion d'injecteur de carburant.

11. Méthode selon la revendication 6, dans laquelle lesdites conditions moyennes incluent le cycle opératoire de commande du ralenti, la vitesse du moteur, l'accélération du moteur ou la position de l'étrangleur.

12. Méthode selon la revendication 8, dans laquelle lesdites conditions déterminées une fois par cycle du moteur incluent la température de chargement de l'air ou la température du liquide de refroidissement du moteur.

13. Appareil destiné à identifier les conditions sélectionnées dans un moteur à combustion comprenant des moyens de contrôle (12) destinés à collecter les données de fonctionnement du moteur provenant du moteur durant plusieurs tests de fonctionnement du moteur, chaque test incluant au moins l'une parmi plusieurs conditions de fonctionnement du moteur sélectionnées connues, les données collectées par les moyens de contrôle correspondant à plusieurs paramètres du moteur, lesdits paramètres incluant des paramètres d'événement d'allumage individuel ; des moyens de traitement (13) destinés à analyser et à formater les données de fonctionnement pour les entrer en tant que vecteurs de formation dans une base de données (16) ; des moyens (15) destinés à entrer des codes de condition correspondant à des conditions de fonctionnement du moteur respectives, les entrées de vecteurs de formation dans la base de données étant divisées en plusieurs ensembles correspondant respectivement aux conditions de fonctionnement du moteur sélectionnées et chaque vecteur dans chaque ensemble étant associé à un code de condition correspondant à la condition de fonctionnement respective ; et des moyens de reconnaissance des formes (14) couplés à la base de données (16) destinés à reconnaître des vecteurs d'entrée basés sur des données de diagnostic présentées à ceux-ci à partir d'un moteur devant être diagnostiqué et à régénérer au moins un code de condition correspondant à au moins l'une desdites conditions de fonctionnement du moteur devant être diagnostiqué.

14. Appareil selon la revendication 13, dans lequel les données collectées par les moyens de contrôle incluent des valeurs numériques et des valeurs analogiques, lesdites valeurs numériques étant contrôlées lors de l'occurrence d'une transition dans celles-ci et lesdites valeurs analogiques étant contrôlées à des intervalles prédéterminées.
